# EUROPEAN PATENT SPECIFICATION

(11) **EP 2 659 520 B1**
(45) Date of publication and mention of the grant of the patent: **03.10.2018**
(21) Application number: 11853239.9
(22) Date of filing: 28.12.2011
(51) Int. Cl.: H01L 31/049

(54) **BACK SHEET FOR SOLAR CELLS AND METHOD FOR PREPARING THE SAME**
RÜCKSEITENFOLIE FÜR SOLARZELLEN UND HERSTELLUNGSVERFAHREN DAFÜR
FEUILLE NOIRE POUR CELLULES SOLAIRES ET PROCÉDÉ POUR SA PRÉPARATION

(30) Priority: 28.12.2010 KR 20100136613
(43) Date of publication of application: 06.11.2013
(73) Proprietor: Youl Chon Chemical Co. Ltd., Seoul 156-709 (KR)
(72) Inventor: JUNG, Jae Chul, Daejeon 305-325 (KR); KANG, Han Joon, Suwon-si Gyeonggi-do 440-725 (KR); HAN, Hee Sik, Dongjak-gu Seoul 156-709 (KR); LEE, Sung Ho, Ansan-si Gyeonggi-do 425-726 (KR); KIM, Jin Ho, Anyang-si Gyeonggi-do 431-788 (KR)
(74) Representative: Zacco Sweden AB
(86) International application number: PCT/KR2011/010255
(87) International publication number: WO 2012/091462

(56) References cited:
- JP-A- 2006 278 709
- JP-A- 2009 081 301
- JP-A- 2010 109 038
- KR-A- 20050 106 168
- KR-A- 20100 111 975
- KR-B1- 100 962 642
- KR-B1- 100 962 642
- KR-B1- 100 999 460
- US-A1- 2010 288 333

## Description

### Technical Field

This disclosure relates to a back sheet for solar cells and a method for preparing the same.

### Background Art

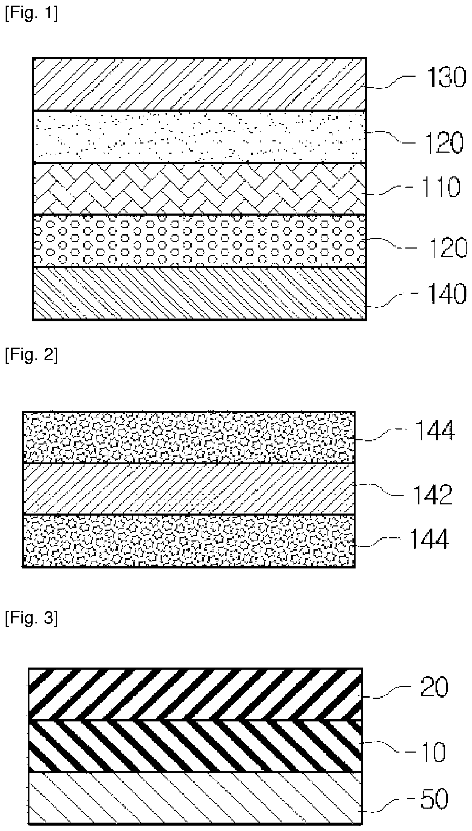

In general, a solar cell may include a semiconductor device 110 having ethylene vinyl alcohol (EVA) sheets 120 on the top and bottom thereof. In addition, a glass substrate 130 may be formed on one of the EVA sheets 120 and a back sheet 140 may be formed on the other EVA sheet 120 (see Fig. 1).

Such solar cells may generally use EVA polymer materials, and thus are not good at dissipating heat generated from the solar cells and their peripheral instruments, thereby resulting in a low efficiency of the solar cells.

Conventional back sheets that are in contact with the EVA sheets may include fluororesin layers 144 formed on one side and the other side of the substrate 142. Particular examples of the fluororesin may include polyvinylidene fluoride (PVDF) or polyvinyl fluoride (PVF)(see Fig. 2). Such fluororesin layers 144 (e.g. PVDF or PVF layers) have an excellent durability.

However, such conventional back sheets are expensive and thus may result in a low manufacturing cost efficiency. In addition, they may have no or poor heat dissipation and thus lower a power generation efficiency of solar cells. KR 100 962 642 B1 discloses a backsheet for solar cells comprising (i) a double pressure sensitive adhesive tape (55), (ii) a fluoro resin (50), (iii) an aluminium layer (60) and a heat dissipating carbon nanotubes (CNT) coating layer (61)/(62).

### Disclosure of Invention

### Technical Problem

In embodiments of the present invention, provided is a back sheet for solar cells having an excellent heat dissipation as well as an excellent durability so as to improve an efficiency of solar cells. Further provided is a method for preparing the back sheet for solar cells.

### Solution to Problem

In embodiments of the invention, provided is a back sheet for solar cells, including a substrate, a fluororesin layer existing on one side of the substrate and a heat-dissipating ink layer existing on the other side of the substrate, wherein the heat-dissipating ink layer is formed by a heat-dissipating ink composition comprising 20 to 300 weight parts of a heat-dissipating material based on 100 weight parts of a binder resin, wherein the substrate consists of at least one selected from the group consisting of polyethylene terephthalate (PET), polybutylene terephthalate (PBT), polyethylene naphthalate (PEN), polybutylene naphthalate (PBN), low-density polyethylene (LDPE), linear low-density polyethylene (LLDPE), high-density polyethylene (HDPE) and polypropylene (PP) .

In another embodiments of the invention, provided is a method for producing a back sheet for solar cells, including forming a fluororesin layer on one side of a substrate and forming a heat-dissipating ink layer on the other side of the substrate.

In still another embodiments of the invention, provided is a solar cell including the back sheet for solar cells.

In an example embodiment of the invention, the back sheet for solar cells may further include a metal layer between the substrate and the heat-dissipating ink layer.

In another example embodiment of the invention, the back sheet for solar cells may further include a metal anti-corrosive layer between the metal layer and the heat-dissipating ink layer.

### Advantageous Effects of Invention

The back sheet for solar cells according to embodiments of the invention includes a heat-dissipating ink layer that substitutes for a fluororesin layer formed on one side of the conventional back sheets for solar cells. To this end, the back sheet may have a good heat dissipation. In addition, the back sheet may have a manufacturing cost efficiency. Furthermore, when the het-dissipating ink layer substituting for the fluororesin layer is further provided with a metal layer, it is possible to realize an excellent heat dissipation as well as a higher durability. The method for preparing the back sheet for solar cells according to embodiments of the invention may allow a cost-efficient production of solar cells.

### Brief Description of Drawings

The above and other aspects, features and advantages of the disclosed embodiments will be more apparent from the following detailed description taken in conjunction with the accompanying drawings in which:
Fig. 1 is a schematic view showing a conventional solar cell;
Fig. 2 is a schematic view showing a conventional back sheet for solar cells;
Fig. 3 is a schematic view showing a back sheet for solar cells, including a substrate, a fluororesin layer and a heat-dissipating ink layer according to an example embodiment of the invention;
Fig. 4 is a schematic view showing a back sheet for solar cells, including a substrate, a fluororesin layer, a metal layer and a heat-dissipating ink layer according to another example embodiment of the invention; and
Fig. 5 is a schematic view showing a back sheet for solar cells, including a substrate, a fluororesin layer, a metal layer, a metal anti-corrosive layer and a heat-dissipating ink layer according to another example embodiment of the invention.

### Mode for the Invention

Example embodiments now will be described more fully hereinafter with reference to the accompanying drawings, in which example embodiments are shown. The present disclosure may, however, be embodied in many different forms and should not be construed as limited to the example embodiments set forth therein. Rather, these example embodiments are provided so that the present disclosure will be thorough and complete, and will fully convey the scope of the present disclosure to those skilled in the art. In the description, details of well-known features and techniques may be omitted to avoid unnecessarily obscuring the presented embodiments.

The terminology used herein is for the purpose of describing particular embodiments only and is not intended to be limiting of the present disclosure. As used herein, the singular forms "a", "an, "the" are intended to include the plural forms as well, unless the context clearly indicates otherwise. Furthermore, the use of the terms a, an, etc. does not denote a limitation of quantity, but rather denotes the presence of at least one of the referenced item.

It will be further understood that the terms "comprises" and/or "comprising" or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Fig. 3 is a schematic view showing a back sheet for solar cells including a substrate, a fluororesin layer and a heat-dissipating ink layer according to an example embodiment.

As shown in Fig. 3, the back sheet for solar cells may include a substrate 10, a fluororesin layer 20 and a heat-dissipating ink layer 50. The fluororesin layer 20 is formed on one side of the substrate 10 and the heat-dissipating ink layer 50 is formed on the other side of the substrate 10.

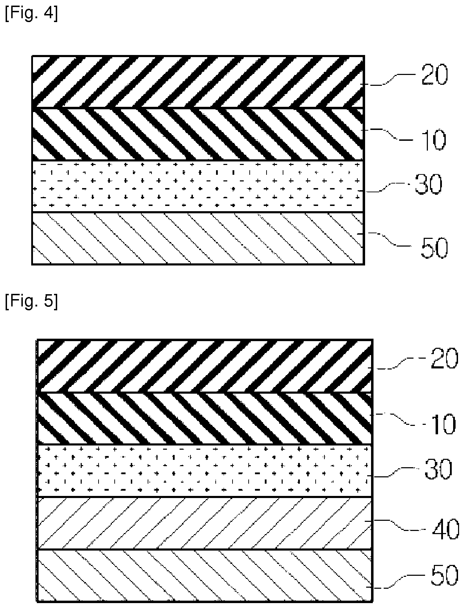

Fig. 4 is a schematic view showing a back sheet for solar cells, including a substrate, a fluororesin layer, a metal layer and a heat-dissipating ink layer according to another example embodiment.

As shown in Fig. 4, the back sheet for solar cells may include a substrate 10, a fluororesin layer 20, a metal layer 30 and a heat-dissipating ink layer 50. The fluororesin layer 20 is formed on one side of the substrate 10, the heat-dissipating ink layer 50 is formed on the other side of the substrate 10, and the metal layer 30 is formed between the substrate 10 and the heat-dissipating ink layer 50.

Fig. 5 is a schematic view showing a back sheet for solar cells, including a substrate, a fluororesin layer, a metal layer, a metal anti-corrosive layer and a heat-dissipating ink layer according to another example embodiment.

As shown in Fig. 5, the back sheet for solar cells may further include a metal anti-corrosive layer 40 formed between the metal layer 30 and the heat-dissipating ink layer 50.

The method for preparing a back sheet for solar cells according to an example embodiment of the invention may include forming a fluororesin layer 20 on one side of a substrate 10 and coating the other side of the substrate 10 with a heat-dissipating ink to form a heat-dissipating ink layer 50 on the other side of the substrate 10.

According to another example embodiment, the method may include forming a fluororesin layer 20 on one side of a substrate 10, forming a metal layer 30 on the other side of the substrate 10 and coating the metal layer 30 with a heat-dissipating ink to form the heat-dissipating layer 50 on the metal layer 30.

According to another example embodiment, the method may further include forming a metal anti-corrosive layer 40 on the metal layer 30 before forming the heat-dissipating ink layer 50 on the metal layer 30, and coating the metal anti-corrosive layer 40 with the heat-dissipating ink to form the heat-dissipating layer 50 on the metal anti-corrosive layer 40.

The heat-dissipating ink may be a heat-conductive ink including a heat-conudctive material. In an example embodiment, the heat-dissipating ink layer may include a carbon material or a metallic filler. The carbon material may include graphites, carbon nanofibers or carbon nanotubes, more preferably graphites. The metallic filler may include a metal powder as the metallic filler having a high heat conductivity, and particular examples thereof may include at least one metal powder selected from the group consisting of aluminum, gold, silver, copper, nickel, tin, zinc, tungsten, stainless steel, iron, etc.

Explaining in detail, the heat-dissipating ink may comprise a heat-dissipating material (heat-conductive material) and binder resin. The heat-dissipating material may be in the form of particles, which can serve as a heat-conduction effective material. The binder resin may allow the binding force between the heat-dissipating materials such as the heat-dissipating materials in the form of particles. The binder resin may also allow the binding force between the heat-dissipating material and the metal layer (or the metal anti-corrosive layer). As explained above, in an embodiment, the heat-dissipating material may be carbon materials, metal particles as the metallic filler, or any combination thereof. The carbon material may be graphites, graphenes, CNTs (carbon nanotubes), CNFs (carbon nano fibers) or any combination thereof. In a non-limiting example, the particle size of the carbon material may be 200*µ*m or less, in particular, 5nm to 200*µ*m. As explained above, as for the metal particles, Al, Au, Ag, Cu, Ni, Sn, Zn, W, Fe, or any combination thereof may be used. In particular, as the metal particles, one single metal (for example, a single metal selected from the above-mentioned metals), or a mixture of metals (for example, a mixture of two or more metals selected from the above-metioned metals), or a metal alloy (for example, a metal alloy of two or more metals selected from the above-metioned metals) may be used. As the metal alloy, a stainless steel may be used.

The binder resin is not limited to a specific binder resin as long as it has an adhesive property and may be selected from a natural resin or a synthetic resin. As for the binder resin, acryl-based resin, epoxy-based resin, urethane-based resin, urea-based resin, polyolefin-based resin (for example, polyethylene, polypropylene, etc.) or any combination thereof may be used.

The heat-dissipating ink layer may be formed by coating a heat-dissipating ink composition comprising 20 to 300 weight parts of a heat-dissipating material based on 100 weight parts of a binder resin. The heat-dissipating ink composition may be in the form of liquid or paste. If the amount of the heat-dissipating material is less than 20 weight parts, a heat-conductivity may be low, thereby resulting in a poor enhancement of the heat-dissipating property. If the amount of the heat-dissipating material is more than 300 weight parts, a coating property may be lowered and a binding force may be lowered since the heat-dissipating ink has a relatively small amount of the binder resin.

In addition, if necessary, the heat-dissipating ink composition may further comprise photoinitiator, curing agent, dispersant, solvent, antioxidant, antifoaming agent, etc., or any combination thereof.

The heat-dissipating ink composition may be coated one or more times by using coating methods such as Spin coating, Bar coating, Ink-jet coating, Gravure coating, Micro Gravure coating, Kiss Gravure coating, Comma Knife coating, Roll coating, Spray coating, Meyer Bar coating, Slot Die coating, Reverse coating, Flexo coating, Offset coating, etc.

The heat-dissipating ink layer may have a thickness controlled as required. In an non-limiting example, the heat-dissipating ink layer may have a thickness of tens of nanometer to 200*µ*m, and preferably, the heat-dissipating ink layer may have a thickness of 5*µ*m to 90*µ*m, and more preferably 20*µ*m to 60*µ*m. When the heat-dissipating ink layer has a thickness less than 5*µ*m, an enhancement of heat-dissipating property and durability may be poor, and the heat-radiationg property may be reduced partially due to a surface scratch caused by an external impact. When the heat-dissipating ink layer has a thickness more than 90*µ*m, it may cause an increase in a production cost. When the thickness of the heat-dissipating ink layer is more than 200*µ*m, it may lower a flexibility of a back sheet and may not be preferable in terms of cost.

According to an example embodiment, the heat-dissipating ink layer may be provided with a high heat-conductivity in a horizontal direction and a vertical direction while the heat-dissipating ink composition is compressed during the formation of the heat-dissipating ink layer.

According to an example embodiment, the heat-dissipating ink layer disclosed herein substitute for the conventional polyvinylidene fluoride (PVDF) layer 144 as showin in Fig. 2 and thus allow a higher heat-conductivity. Therefore, the heat-dissipating ink layer may have a higher heat-dissipating effect than the conventional back sheet for solar cells and thus improve the electricity generation efficiency of solar cells. In addition, even under high-temperature and high-humidity conditions, the heat-dissipating ink layer may prevent the inner materials of solar cells from being in contact with moisture and thus improve the physical properties such as anti-corrosive property and moisture resistance of a back sheet for solar cells, thereby resulting in an improvement of the service life of solar cells. Further, when using the heat-dissipating ink layer instead of the conventional PVDF layer 144, it is possible to realize a high manufacturing cost efficiency.

The fluororesins in the fluororesin layer have an excellent moisture resistance, and thus prevent moisture from penetrating into the back surface of solar cells. In this manner, fluororesins may serve to protect inner materials of solar cells from the external environment. Non-limiting examples of such fluororesins may include polyvinylidene fluoride (PVDF) or polyvinyl fluoride (PVF).

In an example embodiment, the substrate may be made of polyester, polyolefin, polyamide or paper. Preferably, the substrate may include at least one material selected from the group consisting of polyethylene terephthalate (PET), polybutylene terephthalate (PBT), polyethylene naphthalate (PEN), polybutylene naphthalate (PBN), low-density polyethylene (LDPE), linear low-density polyethylene (LLDPE), high-density polyethylene (HDPE) and polypropylene (PP).

In an example embodiment, the metal layer may include any metal having a high heat-conductivity. Preferably, the metal layer may include at least one selected from the group consisting of aluminum, gold, silver, copper, nickel, tin, zinc, tungsten, stainless steel and iron. Since the metal layer has a higher heat-dissipating effect than a fluororesin layer such as PVDF layer, it is possible to improve the electricity generation efficiency of solar cells.

In an example embodiment, the metal layer may have a thickness controlled as required. Preferably, the metal layer has a thickness of 15*µ*m to 120*µ*m, and more particularly 60*µ*m to 100*µ*m. When the metal layer has a thickness less than 15*µ*m, it may show an insufficient heat-conduction effect, resulting in a degradation of heat-dissipating property. When the metal layer has a thickness more than 120*µ*m, it may cause a degradation of processability and cost efficiency.

Under high-temperature and high-humidity conditions, the metal layer may be corroded with ease by moisture, thereby causing a degradation of the durability of solar cells. By using the metal anti-corrosive layer, the durability of solar cells may be improved.

The metal anti-corrosive layer is not limited to a specific one as long as it prevents a corrosion of the metal layer. The metal anti-corrosive layer may include known anti-corrosive agents, which are generally used to prevent the corrosion of the metal. One or more anti-corrosive agents such as phosphate-based (phosphate-treated), chrome-based (chrome-treated) etc, may be used to form the metal anti-corrosive layer. Further, organic materials such as silane-based compounds which are forming a siloxane bond (Si-O-Si) with metals, alkanethiol-based compounds having thiol groups (-SH) which are forming metal-sulfur (S) covalent bonding, etc., may be coated to form the metal anti-corrosive layer.

In an example embodiment, the metal anti-corrosive layer may have a thickness of 0.5*µ*m to 10*µ*m. When the metal anti-corrosive layer has a thickness less than 0.5*µ*m, it may show an insufficient effect of preventing metal corrosion. When the metal anti-corrosive layer has a thickness more than 10*µ*m, it may cause a degradation of heat-dissipating property and low cost efficiency.

In another embodiments of the present invention, there is provided a solar cell including the back sheet for solar cells disclosed herein.

The examples and experiments will now be described. The following examples and experiments are for illustrative purposes only and not intended to limit the scope of this disclosure.

### [Experiment 1] Measurement of heat-dissipating property

A PVDF layer is formed on one side of a PET substrate. Next, a heat-dissipating ink layer is formed on the other side of the PET substrate to have a thickness of 25*µ*m, thereby preparing a back sheet for solar cells (Example 1, Fig. 3). In a variant, a PVDF layer is formed on one side of a PET substrate, an aluminum (Al) layer is formed on the other side of the PET substrate to have a thickness of 80*µ*m, and a heat-dissipating ink layer is formed on the aluminum (Al) layer to have a thickness of 25*µ*m, thereby preparing a back sheet for solar cells (Example 2, Fig. 4). In another variant, a PVDF layer is formed on one side of the PET substrate, an aluminum (Al) layer is formed on the other side of the substrate to have a thickness of 80*µ*m, a phosphate-based metal anti-corrosive layer is formed on the aluminum (Al) layer to have a thickness of 1*µ*m, and a heat-dissipating ink layer is formed on the metal anti-corrosive layer to have a thickness of 25*µ*m to provide a back sheet for solar cells (Example 3, Fig. 5).

Herein, the heat-dissipating ink layer is formed by coating a heat-dissipating ink composition in a liquid form having acryl resin and graphite powder (weight ratio of arcyl resin and graphite powder is 1:1). The phosphate-based metal anti-corrosive layer is formed on the the aluminum (Al) layer by treating surfaces of the aluminum (Al) with phosphate.

In addition, PVDF layers are formed on the one side and the other side of a PET substrate to prepare a conventional back sheet for solar cells (Comparative Example 1, Fig. 2).

The back sheets for solar cells according to Examples 1-3 and Comparative Example 1 are subjected to the following durability test, heat-dissipating property test and electricity generation efficiency test.

The durability test is carried out with a Xenon Weather-Ometer (ATLAS Ci3000+) for 3000 hours and in a constant temperature/constant humidity chamber (80°C, 80% RH) for 3000 hours. The durability of the back sheet according to each Example is evaluated based on the following criteria as shown in Table 1: Excellent (⊚), Good (○), Unsatisfactory (Δ).

The heat-dissipating property test is carried out by measuring a drop in temperature based on 100°C heat source, and table 1 shows the resultant temperature together with the quality grade (Excellent (⊚), Good (Δ), Poor (×)).

With regard to the electricity generation efficiency, each back sheet according to Examples 1-3 and Comparative Example 1 is supplied to consumers, so that they evaluate the relative electricity generation efficiency of solar cell using the back sheet according to each Example with the percentage of the heat generation efficiency (100%) of solar cells using the back sheet of Comparative Example 1. Table 1 shows the resultant percentages together with each heat generation per day.

### Table 1

**[Table 1]**

| | Comparative Example 1 | Example 1 | Example 2 | Example 3 |
|---|---|---|---|---|
| Durability | ⊚ | ⊚ | Δ | ⊚ |
| heat -dissipatingp roperty | X(100°C) | Δ(90°C) | ⊚ (85°C) | ⊚(85°C) |
| Electricity generation efficiency | 100% (14.1Kw/day) | 110% (15.5 Kw/ day) | 115% (16.2 Kw/ day) | 115% (16.2 Kw/day) |

### Industrial Applicability

A back sheet for solar cells and a method for preparing the same are provided. The back sheet for solar cells may have a higher heat-dissipating property as compared to the conventional back sheet for solar cells and attribute to a reduction of manufacturing cost.

## Claims

1. A back sheet for solar cells, comprising:
a substrate;
a fluororesin layer existing on one side of the substrate; and
a heat-dissipating ink layer existing on the other side of the substrate,
wherein the heat-dissipating ink layer is formed by a heat-dissipating ink composition comprising 20 to 300 weight parts of a heat-dissipating material based on 100 weight parts of a binder resin,
wherein the substrate consists of at least one selected from the group consisting of polyethylene terephthalate (PET), polybutylene terephthalate (PBT), polyethylene naphthalate (PEN), polybutylene naphthalate (PBN), low-density polyethylene (LDPE), linear low-density polyethylene (LLDPE), high-density polyethylene (HDPE) and polypropylene (PP).

2. The back sheet for solar cells according to claim 1, further comprising a metal layer between the substrate and the heat-dissipating ink layer.

3. The back sheet for solar cells according to claim 2, further comprising a metal anti-corrosive layer between the metal layer and the heat-dissipating ink layer.

4. The back sheet for solar cells according to any of claims 1 to 3, wherein the heat dissipating material comprises at least one selected from the group consisting of a carbon material and a metallic filler.

5. The back sheet for solar cells according to claim 4, wherein the carbon material is at least one selected from the group consisting of graphite, carbon nanofiber and carbon nanotube.

6. The back sheet for solar cells according to claim 4, wherein the heat-dissipating ink layer has a thickness of 5*µ*m to 90*µ*m.

7. The back sheet for solar cells according to any of claims 1 to 3, wherein the fluororesin is polyvinylidene fluoride (PVDF) or polyvinyl fluoride (PVF).

8. The back sheet for solar cells according to claim 2 or 3, wherein the metal of the metal layer is at least one selected from the group consisting of aluminum, gold, silver, copper, nickel, tin, zinc, tungsten, stainless steel and iron.

9. The back sheet for solar cells according to claim 2 or 3, wherein the metal layer has a thickness of 15*µ*m to 120*µ*m.

10. The back sheet for solar cells according claim 3, wherein the metal anti-corrosive layer is a phosphate-treated or chrome-treated anti-corrosive layer.

11. The back sheet for solar cells according to claim 3, wherein the metal anti-corrosive layer has a thickness of 0.5*µ*m to 10*µ*m.

12. A method for preparing a back sheet for solar cells, comprising:
forming a fluororesin layer on one side of a substrate; and
forming a heat-dissipating ink layer on the other side of the substrate,
wherein the heat-dissipating ink layer is formed by a heat-dissipating ink composition comprising 20 to 300 weight parts of a heat-dissipating material based on 100 weight parts of a binder resin,
wherein the substrate consists of at least one selected from the group consisting of polyethylene terephthalate (PET), polybutylene terephthalate (PBT), polyethylene naphthalate (PEN), polybutylene naphthalate (PBN), low-density polyethylene (LDPE), linear low-density polyethylene (LLDPE), high-density polyethylene (HDPE) and polypropylene (PP).

13. The method according to claim 12, further comprising:
forming a metal layer on the other side of the substrate; and
forming the heat-dissipating ink layer on the metal layer.

14. The method according to claim 13, further comprising:
forming a metal layer on the other side of the substrate;
forming a metal anti-corrosive layer on the metal layer; and
forming the heat-dissipating ink layer on the metal anti-corrosive layer.

15. A solar cell comprising the back sheet for solar cells according to any of claims 1 to 3.

## Patentansprüche

1. Rückseitenfolie für Solarzellen, umfassend:
ein Substrat;
eine Fluorharzschicht, die auf einer Seite des Substrats vorhanden ist; und
eine wärmeableitende Tintenschicht, die auf der anderen Seite des Substrats vorhanden ist,
wobei die wärmeableitende Tintenschicht durch eine wärmeableitende Tintenzusammensetzung gebildet ist, die zu 20 bis 300 Gewichtsteilen ein wärmeableitendes Material, basierend auf 100 Gewichtsteilen eines Bindemittelharzes, umfasst,
wobei das Substrat aus mindestens einem besteht, das ausgewählt ist aus der Gruppe bestehend aus Polyethylenterephthalat (PET), Polybutylenterephthalat (PBT), Polyethylennaphthalat (PEN), Polybutylennaphthalat (PBN), Polyethylen niedriger Dichte (LDPE), linearem Polyethylen niedriger Dichte (LLDPE), Polyethylen hoher Dichte (HDPE) und Polypropylen (PP).

2. Rückseitenfolie für Solarzellen nach Anspruch 1, ferner umfassend eine Metallschicht zwischen dem Substrat und der wärmeableitenden Tintenschicht.

3. Rückseitenfolie für Solarzellen nach Anspruch 2, ferner umfassend eine Metallkorrosionsschutzschicht zwischen der Metallschicht und der wärmeableitenden Tintenschicht.

4. Rückseitenfolie für Solarzellen nach einem der Ansprüche 1 bis 3, wobei das wärmeableitende Material mindestens eines umfasst, das aus der Gruppe ausgewählt ist, die aus einem Kohlenstoffmaterial und einem metallischen Füllstoff besteht.

5. Rückseitenfolie für Solarzellen nach Anspruch 4, wobei das Kohlenstoffmaterial mindestens eines ist, das aus der Gruppe ausgewählt ist, die aus Graphit, Kohlenstoff-Nanofaser und Kohlenstoff-Nanoröhrchen besteht.

6. Rückseitenfolie für Solarzellen nach Anspruch 4, wobei die wärmeableitende Tintenschicht eine Dicke von 5 *µ*m bis 90 *µ*m aufweist.

7. Rückseitenfolie für Solarzellen nach einem der Ansprüche 1 bis 3, wobei das Fluorharz Polyvinylidenfluorid (PVDF) oder Polyvinylfluorid (PVF) ist.

8. Rückseitenfolie für Solarzellen nach Anspruch 2 oder 3, wobei das Metall der Metallschicht mindestens eines ist, das aus der Gruppe ausgewählt ist, die aus Aluminium, Gold, Silber, Kupfer, Nickel, Zinn, Zink, Wolfram, rostfreiem Stahl und Eisen besteht.

9. Rückseitenfolie für Solarzellen nach Anspruch 2 oder 3, wobei die Metallschicht eine Dicke von 15 *µ*m bis 120 *µ*m aufweist.

10. Rückseitenfolie für Solarzellen nach Anspruch 3, wobei die Metallkorrosionsschutzschicht eine phosphatbehandelte oder chrombehandelte Korrosionsschutzschicht ist.

11. Rückseitenfolie für Solarzellen nach Anspruch 3, wobei die Metallkorrosionsschutzschicht eine Dicke von 0,5 *µ*m bis 10 *µ*m aufweist.

12. Verfahren zur Herstellung einer Rückseitenfolie für Solarzellen, umfassend:
Bilden einer Fluorharzschicht auf einer Seite eines Substrats; und
Bilden einer wärmeableitenden Tintenschicht auf der anderen Seite des Substrats,
wobei die wärmeableitende Tintenschicht durch eine wärmeableitende Tintenzusammensetzung gebildet ist, die zu 20 bis 300 Gewichtsteilen ein wärmeableitendes Material, basierend auf 100 Gewichtsteilen eines Bindemittelharzes, umfasst,
wobei das Substrat aus mindestens einem besteht, das ausgewählt ist aus der Gruppe bestehend aus Polyethylenterephthalat (PET), Polybutylenterephthalat (PBT), Polyethylennaphthalat (PEN), Polybutylennaphthalat (PBN), Polyethylen niedriger Dichte (LDPE), linearem Polyethylen niedriger Dichte (LLDPE), Polyethylen hoher Dichte (HDPE) und Polypropylen (PP).

13. Verfahren nach Anspruch 12, ferner umfassend:
Bilden einer Metallschicht auf der anderen Seite des Substrats; und
Bilden der wärmeableitenden Tintenschicht auf der Metallschicht.

14. Verfahren nach Anspruch 13, ferner umfassend:
Bilden einer Metallschicht auf der anderen Seite des Substrats;
Bilden einer Metallkorrosionsschutzschicht auf der Metallschicht; und
Bilden der wärmeableitenden Tintenschicht auf der Metallkorrosionsschutzschicht.

15. Solarzelle, umfassend die Rückseitenfolie für Solarzellen nach einem der Ansprüche 1 bis 3.

## Revendications

1. Feuille de support pour cellules solaires, comprenant :
un substrat ;
une couche de résine fluorée existant sur un côté du substrat ; et
une couche d'encre de dissipation de chaleur existant de l'autre côté du substrat,
dans laquelle la couche d'encre de dissipation de chaleur est formée par une composition d'encre de dissipation de chaleur comprenant 20 à 300 parties en poids d'un matériau de dissipation de chaleur sur la base de 100 parties en poids d'une résine liante,
dans laquelle le substrat est constitué d'au moins un matériau choisi du groupe constitué de téréphtalate de polyéthylène (PET), téréphtalate de polybutylène (PBT), naphtalate de polyéthylène (PEN), naphtalate de polybutylène (PBN), polyéthylène basse densité (LDPE), polyéthylène linéaire basse densité (LLDPE), polyéthylène haute densité (HDPE) et polypropylène (PP).

2. Feuille de support pour cellules solaires selon la revendication 1, comprenant en outre une couche métallique entre le substrat et la couche d'encre de dissipation de chaleur.

3. Feuille de support pour cellules solaires selon la revendication 2, comprenant en outre une couche anti-corrosion métallique entre la couche métallique et la couche d'encre de dissipation de chaleur.

4. Feuille de support pour cellules solaires selon l'une quelconque des revendications 1 à 3, dans laquelle le matériau de dissipation de chaleur comprend au moins l'un choisi du groupe constitué d'un matériau carboné et d'une charge métallique.

5. Feuille de support pour cellules solaires selon la revendication 4, dans laquelle le matériau carboné est au moins l'un choisi du groupe constitué de graphite, nanofibre de carbone et nanotube de carbone.

6. Feuille de support pour des cellules solaires selon la revendication 4, dans laquelle la couche d'encre de dissipation de chaleur a une épaisseur de 5 *µ*m à 90 *µ*m.

7. Feuille de support pour cellules solaires selon l'une quelconque des revendications 1 à 3, dans laquelle la résine fluorée est du fluorure de polyvinylidène (PVDF) ou du fluorure de polyvinyle (PVF).

8. Feuille de support pour cellules solaires selon la revendication 2 ou 3, dans laquelle le métal de la couche métallique est au moins l'un choisi du groupe constitué d'aluminium, or, argent, cuivre, nickel, étain, zinc, tungstène, acier inoxydable et fer.

9. Feuille de support pour cellules solaires selon la revendication 2 ou 3, dans laquelle la couche métallique a une épaisseur de 15 *µ*m à 120 *µ*m.

10. Feuille de support pour cellules solaires selon la revendication 3, dans laquelle la couche anti-corrosion métallique est une couche anti-corrosion traitée au phosphate ou traitée au chrome.

11. Feuille de support pour cellules solaires selon la revendication 3, dans laquelle la couche anti-corrosion métallique a une épaisseur de 0,5 *µ*m à 10 *µ*m.

12. Procédé de préparation d'une feuille de support pour cellules solaires, comprenant :
la formation d'une couche de résine fluorée sur un côté d'un substrat ; et
la formation d'une couche d'encre de dissipation de chaleur sur l'autre côté du substrat,
dans lequel la couche d'encre de dissipation de chaleur est formée par une composition d'encre de dissipation de chaleur comprenant 20 à 300 parties en poids d'un matériau de dissipation de chaleur sur la base de 100 parties en poids d'une résine liante,
dans lequel le substrat est constitué d'au moins un matériau choisi du groupe constitué de téréphtalate de polyéthylène (PET), téréphtalate de polybutylène (PBT), naphtalate de polyéthylène (PEN), naphtalate de polybutylène (PBN), polyéthylène basse densité (LDPE), polyéthylène linéaire basse densité (LLDPE), polyéthylène haute densité (HDPE) et polypropylène (PP).

13. Procédé selon la revendication 12, comprenant en outre :
la formation d'une couche métallique sur l'autre côté du substrat ; et
la formation de la couche d'encre de dissipation de chaleur sur la couche métallique.

14. Procédé selon la revendication 13, comprenant en outre :
la formation d'une couche métallique sur l'autre côté du substrat ;
la formation d'une couche anti-corrosion métallique sur la couche métallique ; et
la formation de la couche d'encre de dissipation de chaleur sur la couche anti-corrosion métallique.

15. Cellule solaire comprenant la feuille de support pour cellules solaires selon l'une quelconque des revendications 1 à 3.
